# EUROPEAN PATENT SPECIFICATION

(11) **EP 3 181 730 B1**
(45) Date of publication and mention of the grant of the patent: **20.06.2018**
(21) Application number: 16204194.1
(22) Date of filing: 14.12.2016
(51) Int. Cl.: C23F 11/08, C23F 11/14, C23C 22/58, H05K 3/28

(54) **METHOD FOR FORMING ORGANIC COATING ON NICKEL SURFACE**
VERFAHREN ZUR FORMUNG EINER ORGANISCHEN BESCHICHTUNG AUF EINER NICKELOBERFLÄCHE
PROCÉDÉ DE FORMATION D'UN REVÊTEMENT ORGANIQUE SUR UNE SURFACE EN NICKEL

(30) Priority: 16.12.2015 US 201562267963 P
(43) Date of publication of application: 21.06.2017
(73) Proprietor: Rohm and Haas Electronic Materials LLC, Marlborough, MA 01752 (US)
(72) Inventor: TANG, Qin, Fanling, NT (HK); TONG, Kitho, Fanling, NT (HK); CHAN, Chit Yiu, Taiwai, NT (HK); YEE, Kwok Wai Dennis, Yuen Long (HK)
(74) Representative: Houghton, Mark Phillip

(56) References cited:
- JP-A- 2010 156 043
- US-A1- 2008 261 025
- US-A1- 2014 174 322

## Description

### Field

The present invention relates generally to a method for forming an organic coating on a surface of nickel. In particular, the present invention relates to a method for forming an organic solderability film on a nickel surface to prevent corrosion of nickel without forming known gold immersion film on the surface of the nickel.

### Introduction

Nickel plating (deposition) is used for many electronic applications from its superior properties. Metallic deposition on a copper surface of printed circuit board (PCB) pads is a typical example for the use of nickel plating. The copper surfaces of PCB pads are coated with nickel deposition to maintain good solderability as well as preventing the copper surface from being oxidized either during storage in corrosive environment after PCB fabrication and during exposures to soldering temperatures. In most applications, an inert precious metal such as gold was further plated on the nickel surface to enhance the protection of the copper surface.

However, prices of metals have increased rapidly in recent years. While all metal-containing processes have been affected by the change, processes involving precious metals have been particularly affected. The thickness of gold deposition on the nickel surface becomes thinner and thinner to decrease the amount of deposited gold and production cost. However, the thin outermost layer becomes porous, which causes oxidization of the nickel underlayer coating during storage in corrosive environment. Thus, the solderability of the PCBs pad surface will deteriorate. Therefore, a low cost, solderable and dense protective film on the nickel surface is desired.

Organic solderability preservative (OSP) is used to protect the surface of metals with low-cost and good solderability. Some OSPs on a metallic surface are known such as JP06299374A, JP06299375A, JP2010156043A, US8182879B, CN1568380Aand US20140174322A. But most of those references are for coatings on copper surfaces, or azole compounds such as imidazole or benzimidazole which are known as corrosion inhibitors of copper surfaces.

However, the technology to prevent oxidization on copper surfaces cannot be used for nickel surfaces directly, because the mechanism of preventing oxidization on nickel surfaces is considered to be different from the one on copper surfaces. Therefore, a method for preventing oxidization of nickel surfaces without decreasing solderability is still desired.

### Summary

### The present invention provides a method for forming OSP film on nickel surfaces to effectively prevent oxidization of nickel surfaces.

Therefore, one aspect of the invention relates to a method for forming an organic film on a surface of nickel or nickel alloy comprising contacting the surface of nickel or nickel alloy with a composition comprising a compound represented by the formula (1)

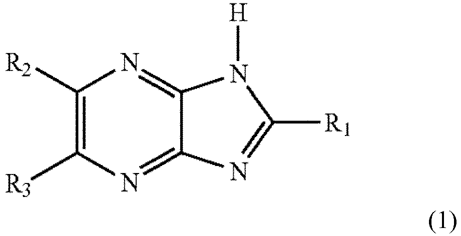

wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure:

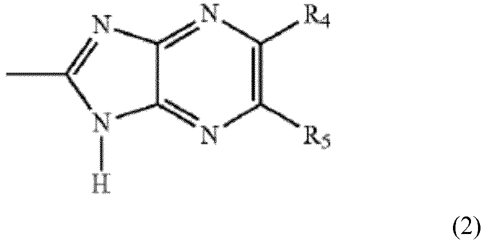

wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms.

Another aspect of the invention relates to an organic film on a surface of nickel or nickel alloy formed by the method described above.

In another aspect, the invention relates to a method for protecting a nickel or nickel alloy surface of an article from oxidation, comprising the steps of: (a) preparing an article having nickel or nickel alloy surface, (b)contacting the nickel or nickel alloy surface of the article with a composition comprising a compound represented by the formula (1) 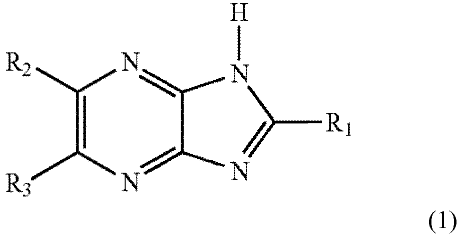 wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 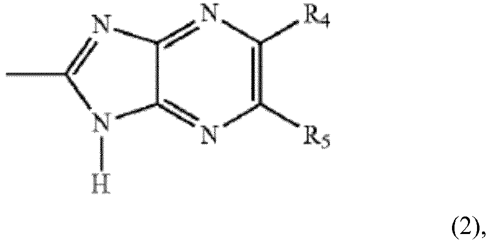 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms, and (c) drying the nickel or nickel alloy surface to form an organic film comprising the compound on the surface.

### Brief description of the drawings

Figure 1 is SEM image of bare nickel surface before HNO₃ test (magnification is 2000 times).
Figure 2 is SEM image of bare nickel surface before HNO₃ test (magnification is 6500 times).
Figure 3 is SEM image of bare nickel surface after HNO₃ test (magnification is 2000 times).
Figure 4 is SEM image of bare nickel surface after HNO₃ test (magnification is 6500 times).
Figure 5 is SEM image of nickel surface with generic OSP treatment after HNO₃ test (magnification is 2000 times).
Figure 6 is SEM image of nickel surface with generic OSP treatment after HNO₃ test (magnification is 6500 times).
Figure 7 is SEM image of nickel surface with PIM treatment after HNO₃ test (magnification is 2000 times).
Figure 8 is SEM image of nickel surface with PIM treatment after HNO₃ test (magnification is 6500 times).
Figure 9 is SEM image of nickel surface with PEM treatment after HNO₃ test (magnification is 2000 times).
Figure 10 is SEM image of nickel surface with PEM treatment after HNO₃ test (magnification is 6500 times).

### Detailed Description

As used throughout this specification, the abbreviations given below have the following meanings, unless the context clearly indicates otherwise: g = gram(s); mg = milligram(s); L = liter(s); mL = milliliter(s); ppm = parts per million; m=meter(s); mm = millimeter(s); cm=centimeter(s); min.= minute(s); s = second(s); hr.= hour(s); °C = degree(s) C = degree(s) Celsius; vol%=volume percent(s) = percent(s) by volume; wt%=weight percent(s) = percent(s) by weight.

The terms "plating" and "deposition" are used interchangeably throughout this specification.

Methods of the present invention are for forming an organic film on a surface of nickel or nickel alloy comprising contacting the surface of nickel or nickel alloy with a composition comprising a specific pyrazine derived compound. The pyrazine derived compound used in the invention is represented by the formula (1)

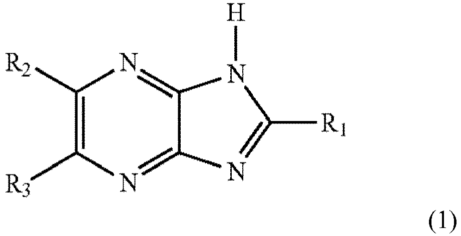

In the formula (1), R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl. R₂ and R₃ may be taken together with all of their atoms to form a five membered heterocyclic ring wherein the heterocyclic ring includes two nitrogen atoms as the hetero-atoms, and R₁ can have the following structure:

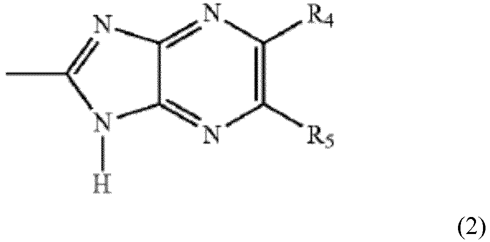

In formula (2), R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl. R₄ and R₅ may be taken together with all of their atoms to form a five membered heterocyclic ring wherein the heterocyclic ring includes two nitrogen atoms as the hetero-atoms.

When R₂ and R₃ are taken together to form a five membered heterocyclic ring, compounds have structure: 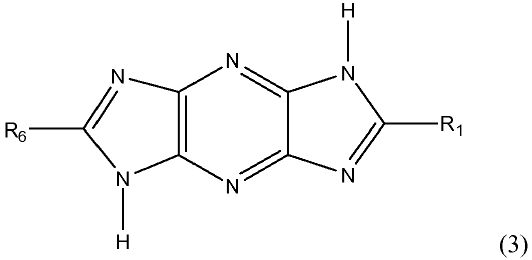 wherein R₁ is defined as above and R₆ is the same as R₁ with the proviso that R₆ is not a structure as formula (2) above.

When R₁ of structure (1) is structure (2) as defined above, the structure is as follows: 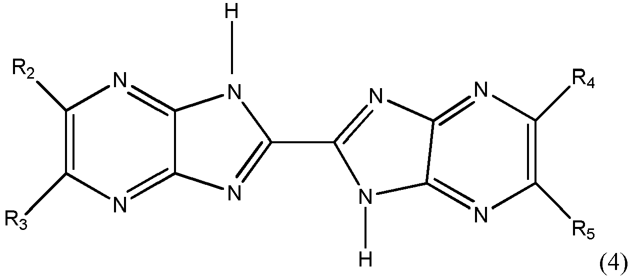 wherein R₂, R₃, R₄ and R₅ are as defined above.

When R₄ and R₅ are taken together to form a five membered heterocyclic ring the structure is as follows: 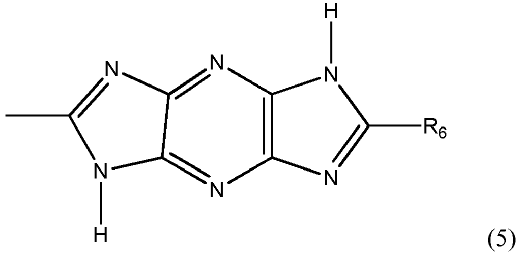 wherein R₆ is as defined above.

Hydrocarbyl typically has from one to twenty-five carbon atoms, preferably from one to twelve carbon atoms, more preferably from one to seven carbon atoms. The hydrocarbyl may be methyl, ethyl, n-propyl, isopropyl, n-butyl, isobutyl, tert-butyl, pentyl, hexyl, heptyl, phenyl or benzyl. Substitutents on substituted hydrocarbyl include, but are not limited to nitro, amino, halide, cyano, carbonyl, carboxyl, hydroxyl and alkoxyl. Halides include fluoride, chloride and bromide, typically the halide is chloride and fluoride, more typically the halide is chloride.

Substituted or unsubstituted, linear or branched alkoxyl and substituted or unsubstituted, linear or branched amino and amide may have from one to twenty-five carbon atoms, preferably from one to twelve carbon atoms and more preferably from one to six carbon atoms. Substitutents on the substituted alkoxyl and substituted amino and amide include but are not limited to, nitro, amino, halide, cyano, carbonyl, carboxyl, hydroxyl and alkoxyl.

Substituted or unsubstituted linear or branched carboxyl and carbonyl may have from one to twenty-five carbon atoms, preferably from one to twelve carbon atoms and more preferably from one to six carbon atoms. Substituents include, but are not limited to nitro, halide and hydroxyl.

Substituted or unsubstituted linear or branched ester and thioester may have from two to twenty-five carbon atoms, preferably from two to twelve carbon atoms and more preferably from two to six carbon atoms. Substituents include, but are not limited to, nitro, halide, hydroxyl and cyano.

Substituted or unsubstituted linear or branched alkylthio groups may have from one to twenty-five carbon atoms, preferably from two to twelve carbon atoms and more preferably from two to six carbon atoms. Substituents include, but are not limited to, nitro, halide, hydroxyl and cyano.

Boryl has the following structure: 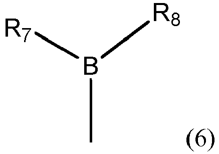 wherein R₇ and R₈ are independently hydrogen, substituted, unsubstituted, linear or branched alkyl groups having from one to ten carbon atoms preferably from one to five carbon atoms, most preferably R₇ and R₈ are hydrogen. Substitutents include, but are not limited to, nitro, hydroxyl and halide.

Silyl has the following structure: 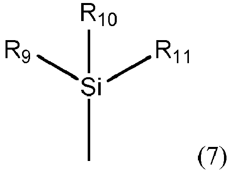 wherein R₉, R₁₀ and R₁₁ are independently hydrogen, or substituted, unsubstituted, linear or branched one to five carbon alkyl; or phenyl. Preferably R₉, R₁₀ and R₁₁ are from one to four carbon alkyl groups or phenyl. Examples of such silyl groups are trimethyl silyl, tert-butyldiphenyl silyl, ter-butyl dimethyl silyl and triisoprpoyl silyl. Substituents include, but are not limited to halide, nitro and hydroxyl.

Preferably R₁, R₂ and R₃ are independently hydrogen, hydroxyl, substituted or unsubstituted, linear or branched alky or alkoxy with one to six carbon atoms. Substituents on the alky and alkoxy include, but are not limited to, hydroxyl, carboxyl, amino and carbonyl. More preferably R₁, R₂ and R₃ are independently hydrogen, hydroxyl, substituted or unsubstituted, linear or branched alkyl with one to five carbon atoms where the substituents include, but are not limited to, hydroxyl and amino. Most preferably, R₁, R₂ and R₃ are independently hydrogen, hydroxyl or hydroxyalkyl having one to five carbon atoms. Even more preferred are when R₁, R₂ and R₃ are hydrogen.

The pyrazine derived compounds having the foregoing structures may be included in the compositions in amounts of 0.1 g/L to 50 g/L, preferably from 1 g/L to 12 g/L, more preferably from 2 g/L to 10 g/L. Such compounds may be commercially obtained or they may be made according to processes known in the art or disclosed in the literature.

The compositions also include one or more acids, preferably, organic acids, to adjust the pH of the compositions to a range of 1-10, preferably from 1-7, more preferably from 2-4. Inorganic acids include, but are not limited to hydrochloric acid, sulfuric acid, nitric acid, phosphoric acid and hydrofluoric acid. Organic acids include, but are not limited to, carboxylic acids and their salts. Such carboxylic acids include, but are not limited to, acetic acid, citric acid tartaric acid, ascorbic acid, malic acid, formic acid and salts thereof. In general, inorganic and organic acids are included in the compositions in amounts of 0.1 g/L to 10 g/L; however, the amount may vary since the acids are included in sufficient amounts to maintain the desired pH.

Solubilizers is typically used to dissolve the active coating ingredient in the solution. Optionally, one or more alcohols may be used to solubilize the active ingredient where the active ingredient is dissolved in the alcohol and then added to the water used to make the treating solution. Such solubilizers include, but are not limited to, 1-butanol, 1-pentanol, 2-pentanol, other pentanols, 1-hexanol, other hexanols, heptanols, furfuryl alcohol, terahydrofurfuryl alcohol and alkyl cyclic alcohol.

One or more sources of metal ions are also included in the compositions. Metal ions are included to increase the rate of film formation, provide for a more uniform film layer and also lower operating temperatures of the compositions. Such metal ions include, but are not limited to copper, tin, zinc, silver, nickel, lead, manganese, barium, palladium and iron. Preferably the metal ions are chosen from copper, tin, zinc, silver, manganese, iron and nickel. More preferably the metal ion is copper. Sources of the metal ions may include any water soluble organic or inorganic metal salt such as water soluble metal salts of halides, nitrates, acetates, sulfates, oxides, alkylsulfonates, formates, gluconates, tartrates, oxalates, acetates and lactates. Many of such metal salts are commercially available or may be made based on disclosures in the literature. In general such salts are included in the compositions in amounts of 0.001 g/L to 5 g/L, preferably from 0.01 g/L to 2 g/L. Such salts are added in amounts to provide metal ions at concentrations of 1 ppm to 5000 ppm, preferably from 10 ppm to 2000 ppm.

Optionally one or more complexing or chelating agents can be included in the composition. Conventional complexing or chelating may be used. Such complexing or chelating agents include, but are not limited to, carboxylic acids, such as acetic acid, formic acid, nitrilo-triacetic acid, tartaric acid, gluconic acid, phthalic acid, citric acid, ethylenediaminetetraacetic acid (EDTA) and
N-(2-hydroxyethyl)ethylenediamine-N,N',N'-triacetic acid trisodium salt (HEDTA), carboxylic acid-substituted N-containing heterocyclic compounds, such as picolinic acid, quinolinic acid, nicotinic acid, fusaric acid, isonipecotic acid, pyridine dicarboxylic acid, piparazine carboxylic acid, pyrrole carboxylic acid and pyrolidine; amino carboxylic acids include, but are not limited to polyamines, amino alcohols, such as ethanolamine and dimethylethanolamine; sulfur containing compounds, such as thiols, disulfides, thioethers, thioaldehydes, thioketones, thiourea and its derivatives, thioglycols, mercaptoacetic acid, mercaptopropionic acid and mercaptosuccinic acid; amines such as ethylenediamine and ammonia; and amino acids, such as glutamic acid, aspartic acid, lysine, histidine, alanine, glycine, glutamine, valine, cysteine and methionine.

The composition is applied to the surface of nickel or nickel alloy to form an organic film on the surface of those metals. Nickel alloy includes, but is not limited, nickel/phosphorus, nickel/cobalt and nickel/boron. Preferably, the OSP film is applied to nickel or nickel alloy deposited on copper. An article having nickel or nickel alloy surface can be treated by the composition. Examples of such articles include PCB pads with nickel or nickel alloy deposit on copper surface.

The composition may be applied to the nickel surface of an article by any suitable process known in the art. Such processes include, but are not limited to, dipping the article into the composition, spraying the composition onto the article or by brushing the composition on the article. In general, the composition is applied at temperatures from room temperature to 90° C, preferably from 30° C to 70° C. Contact time between the nickel or nickel alloy surface of the article and the composition prior to the next processing step may range from one minute to ten minutes, preferably from one minute to five minutes. Optionally the nickel or nickel alloy surface of the article may be air dried at room temperature and then the article may be rinsed with water at room temperature followed by hot air drying at temperatures of 50-70° C. The dried film on the nickel or nickel alloy surface typically forms a uniform layer from 10 nm to 500 nm thick, preferably from 10 nm to 200 nm thick, more preferably from 20 nm to 100 nm thick.

Prior to applying the composition to the nickel or nickel alloy surface of the article, the nickel surface is typically cleaned to remove any organic contamination and surface oxidation. The article is optionally rinsed with water and dried, then contact with the composition.

The methods enable the formation of a continuous and substantially uniform organic film on nickel or nickel alloy surfaces. The film has good anticorrosion properties and thermal stability and retains solderability of nickel and nickel alloy surfaces even after multiple heat cycles.

### Examples

The two chemicals written below were used as pyrazine derived compounds.

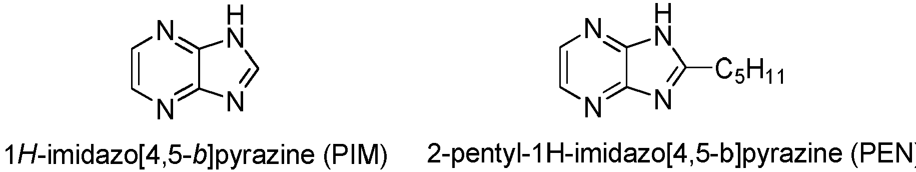

Compositions with the following formulations were prepared.

**Table 1 PIM bath**

| Chemicals | Amounts |
|---|---|
| 1H-imidazole[4,5-b]pyrazine | 0.1 wt% |
| Acetic acid/Ammonia | adjust pH |
| Copper (II) chloride | 60ppm as Copper ions |
| Water | remains |

| | |
|---|---|
| pH of the bath was 3.20. | |

**Table 2 PEN bath**

| Chemicals | Amounts |
|---|---|
| 2-pentyl 1H-imidazole[4,5-b]pyrazine | 0.1 wt% |
| Acetic acid/Ammonia | adjust pH |
| Copper (II) chloride | 100ppm as Copper ions |
| Water | remains |

| | |
|---|---|
| pH of the bath was 4.20. | |

In addition to the above two pyrazine derived compounds, generic OSP solution comprising 0.5% of 2-[(4-chlorophenyl)methyl]-1H-benzimidaozle was used as comparison.

FR-4 copper clad laminates obtained from Fastprint China were treated with the OSP bath according to the process disclosed in Table 3 below.

**Table 3**

| **Step** | **Process Bath** | **Conditions** |
|---|---|---|
| Cleaner | RONACLEAN™ LP-200 sulfuric acid | 40°C, 5 min |
| Water Rinse | - | RT, 2 min |
| Micro-etch | 100 g/l Sodium Persulfate | RT, 2 min |
| | 20 ml/l sulfuric acid | |
| RO Rising | - | RT, 2 min |
| Pre-dip | 5% sulfuric acid | RT, 1min |
| Catalyzing | RONAMAX™ CATALYST CF | RT, 2min |
| RO Rising | - | RT, 1 min |
| Post-dip | 5% sulfuric acid | RT, 1min |
| RO Rising | - | RT, 1 min |
| Electroless Nickel plating | DURAPOSIT™ SMT 88 | 85°C, 22 min |
| RO Rising | - | RT, 2 min |
| OSP Deposition | OSP bath | 50°C, 5 min |
| RO Rinse | - | RT,2 min |
| Hot air dry | - | 50-70° C, 3min |

### (I) Thickness of OSP films

FIB was then used to measure the coating thickness and study the continuity coating of each laminate from cross sections of the laminates. The OSP layer was determined to be continuous and uniform on both laminates. The thickness of PIM film was 40 nm while the thickness of PEN film was 80 nm on each laminate. For comparison, generic OSP solution forms a film with a thickness 150nm under the same conditions.

### (II) Anti-corrosion test

For corrosion test, the samples were dipped in 15% nitric acid at room temperature (25 °C) for 30 minutes and then rinsed with water and dried with cold and hot air. The cross-section views were observed. From the cross-section view of the electroless nickel surfaces after nitric acid test, the bare electroless nickel surface and electroless nickel surface treated with generic OSP solution showed serious corrosion. However, the samples treated with PIM and PEM, showed no apparent corrosion.

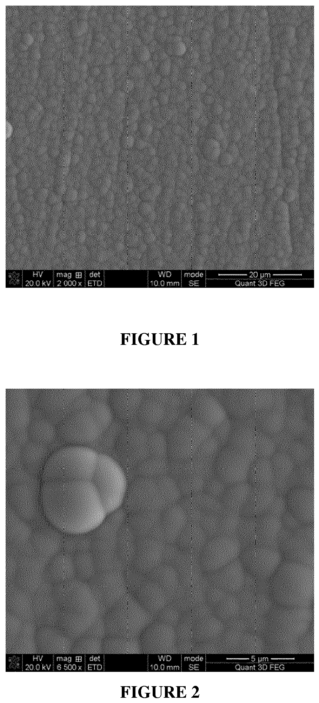

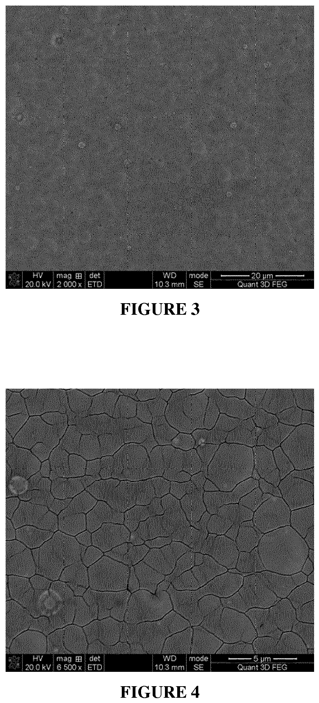

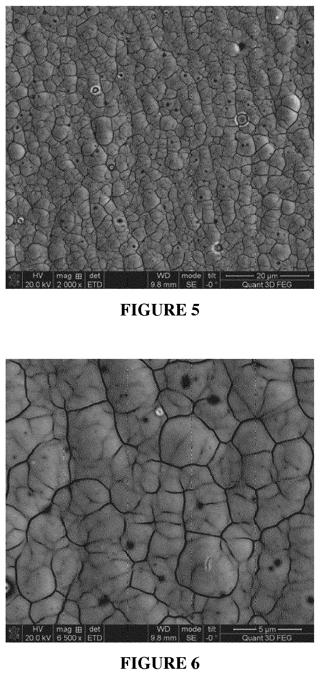

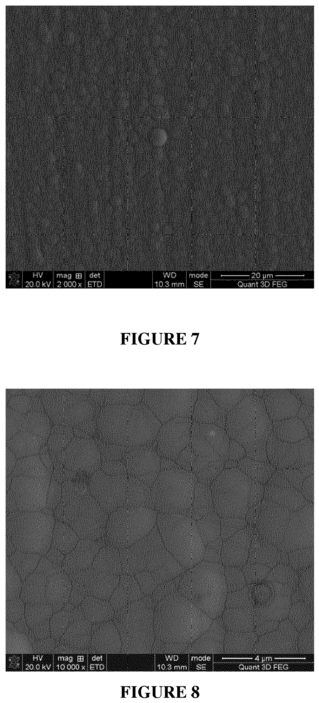

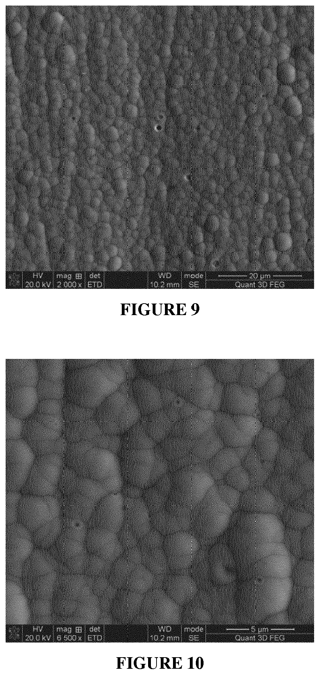

The corresponding SEM images at 20 kV-voltage are shown in Figures 1 to 10. For the bare nickel under 20 kV SEM, no corrosion site was observed (Figures 1 and 2). For the bare nickel sample after treated with 30 min HNO₃ , serious corrosion was observed, especially in the nickel grain boundary (Figures 3 and 4). Figures 5 and 6 are SEM images for nickel surface treated with generic OSP solution after treated with 30 minutes HNO₃. For the nickel treated with generic OSP, the organic layer was fully washed away by the nitric acid. No apparent protective effect was observed from this organic coating. Similar with the bare nickel sample, serious corrosion was observed. For the nickel sample treated with PIM or PEN, the corrosion circumstances were much better. Figures 7 and 8 are SEM images for nickel surface treated with PIM after treated with 30 minutes HNO₃, while Figures 9 and 10 are SEM images for nickel surface treated with PEN after being treated with HNO₃ for 30 minutes. No serious corrosion was observed for the samples treated with PIM or PEN.

### (III) Ball Shear Test

In order to show whether or not the organic preservative on the nickel surface would influence the solder joint formation after the soldering, the ball shear tests were performed and the results were compared with bare nickel surface. The ball shear test parameters were shown in Table 4 below.

**Table 4**

| | |
|---|---|
| Test speed | 200 µm/s |
| Test load | 30 g |
| Land speed | 500 µm/s |
| Shear height | 100 µm |
| Over-travel | 300 µm |
| Ball size (SAC 305) | 0.63 mm |

It was found that there was good shear force and failure mode performance among the OSP samples. And it was implied that the OSP samples would not influence the solder joint formation after the soldering process.

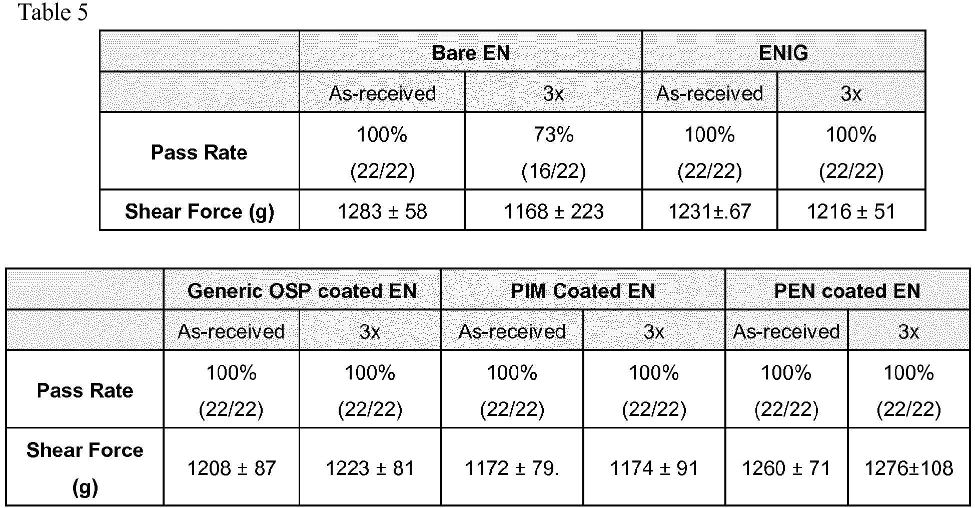

### (IV) Wetting Balance Test

Wetting balance tests were then used to evaluate the solderbility of nickel surface after OSP treated. The test parameters are shown in Table 6 below:

**Table 6**

| | |
|---|---|
| Test time | 1ms |
| Immersion speed | 1 mm/s |
| Removal speed | 10 mm/s |
| Temperature setting | 255 °C |
| Solder | 2 mm SAC 305 |
| Flux | Alpha EF 8000 |

All samples had good solder coverage with acceptable wetting times and wetting forces after the tests and it was implied that the OSP on nickel surface would not influence the solderability of the nickel surface. The results are shown in Table 7 below:

**Table 7**

| | **T_{b}(s)** | **T_{2/3Fmax} (s)** | **Fₘₐₓ (mN)** |
|---|---|---|---|
| **Thin Gold ENIG** (Au thickness 0.03 um) | 0.25 | 0.47 | 2.0 |
| **Fresh EN** | 0.30 | 1.28 | 1.2 |
| **PIM** coated EN | 0.31 | 2.06 | 1.1 |
| **PEN** coated EN | 0.26 | 1.16 | 1.4 |
| **Generic OSP** coated EN | 0.29 | 1.11 | 1.4 |

## Claims

1. A method for forming an organic film on a surface of nickel or nickel alloy comprising contacting the surface of nickel or nickel alloy with a composition comprising a compound represented by the formula (1) 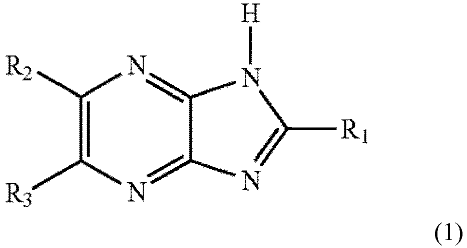 wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 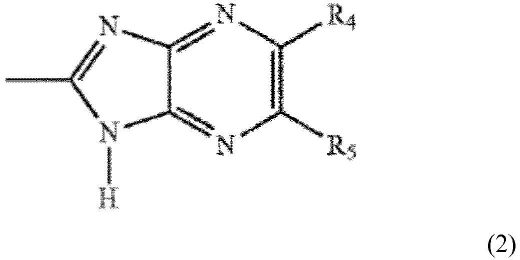 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms.

2. The method of claim 1, wherein the compound is included in the composition in amount of 0.1 g/L to 50 g/L.

3. The method of claim 1, wherein the composition further comprises metal ions selected from Cu, Sn, Zn, Ag, Ni, Pd, Ba, Mg, Fe, Au, Pt, W, Bi, Sb, Mn and Pd.

4. An organic film on a surface of nickel or nickel alloy formed by the method of claim 1.

5. The organic film of claim 4, wherein the thickness of the film is from 10 to 500 nm.

6. A method for protecting a nickel or nickel alloy surface of an article from oxidation, comprising the steps of:
(a) preparing an article having nickel or nickel alloy surface,
(b)contacting the nickel or nickel alloy surface of the article with a composition comprising a compound represented by the formula (1) 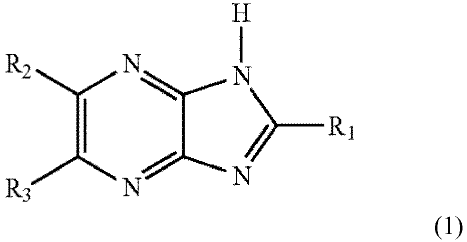 wherein R₁, R₂ and R₃ are independently hydrogen, substituted or unsubstituted, linear, branched or cyclic alkyl, halide, nitro, hydroxyl, cyano, carboxyl, ester, mercapto, alkylthio, thioester, amino, amide, boryl or silyl; R₂ and R₃ may be taken together with all of their atoms to form a five membered heterocyclic ring wherein the heterocyclic ring includes two nitrogen atoms as the hetero-atoms, and R₁ can have the following structure: 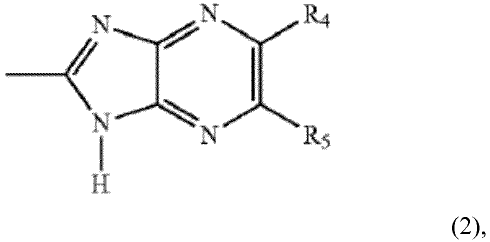 wherein R₄ and R₅ are independently hydrogen, halide, nitro, hydroxyl, cyano, substituted or unsubstituted, linear, branched or cyclic hydrocarbyl, substituted or unsubstituted, linear or branched alkoxyl, carboxyl, ester, mercapto, alkylthio, thioester, amino, amide, boryl or silyl; R₄ and R₅ may be taken together with all of their atoms to form a five membered heterocyclic ring wherein the heterocyclic ring includes two nitrogen atoms as the hetero-atoms, and
(c) drying the nickel or nickel alloy surface to form an organic film comprising the compound on the surface.

7. The method of claim 6, wherein the step (b) is conducted at the temperature of 20 to 70 degrees C for 1 to 30 minutes.

8. The method of claim 6, wherein the article is selected from printed circuit board, electronic components and decorative accessories.

## Patentansprüche

1. Ein Verfahren zum Bilden eines organischen Films auf einer Oberfläche aus Nickel oder Nickellegierung, beinhaltend das In-Kontakt-Bringen der Oberfläche aus Nickel oder Nickellegierung mit einer Zusammensetzung, die eine durch die folgende Formel (1) dargestellte Verbindung beinhaltet: 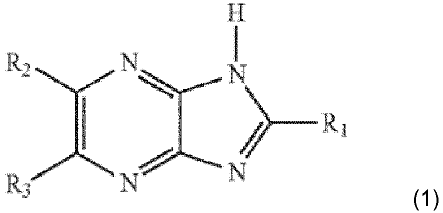 wobei R₁, R₂ und R₃ unabhängig Wasserstoff, substituiertes oder nichtsubstituiertes, lineares, verzweigtes oder cyclisches Alkyl, Halogenid, Nitro, Hydroxyl, Cyano, Carboxyl, Ester, Mercapto, Alkylthio, Thioester, Amino, Amid, Boryl oder Silyl sind; R₂ und R₃ mit all ihren Atomen zusammengenommen werden können, um einen fünfgliedrigen heterocyclischen Ring zu bilden, wobei der heterocyclische Ring zwei Stickstoffatome als die Heteroatome umfasst, und R₁ die folgende Struktur aufweisen kann: 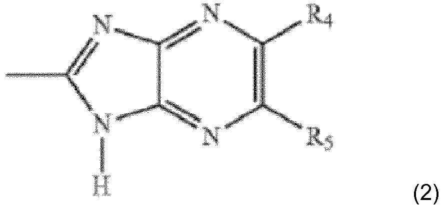 wobei R₄ und R₅ unabhängig Wasserstoff, Halogenid, Nitro, Hydroxyl, Cyano, substituiertes oder nichtsubstituiertes, lineares, verzweigtes oder cyclisches Hydrocarbyl, substituiertes oder nichtsubstituiertes, lineares oder verzweigtes Alkoxyl, Carboxyl, Ester, Mercapto, Alkylthio, Thioester, Amino, Amid, Boryl oder Silyl sind; R₄ und R₅ mit all ihren Atomen zusammengenommen werden können, um einen fünfgliedrigen heterocyclischen Ring zu bilden, wobei der heterocyclische Ring zwei Stickstoffatome als die Heteroatome umfasst.

2. Verfahren gemäß Anspruch 1, wobei die Verbindung in der Zusammensetzung in einer Menge von 0,1 g/l bis 50 g/l umfasst ist.

3. Verfahren gemäß Anspruch 1, wobei die Zusammensetzung ferner aus Cu, Sn, Zn, Ag, Ni, Pd, Ba, Mg, Fe, Au, Pt, W, Bi, Sb, Mn und Pd ausgewählte Metallionen beinhaltet.

4. Ein durch das Verfahren gemäß Anspruch 1 gebildeter organischer Film auf einer Oberfläche aus Nickel oder Nickellegierung.

5. Organischer Film gemäß Anspruch 4, wobei die Dicke des Films von 10 bis 500 nm beträgt.

6. Ein Verfahren zum Schützen einer Nickel- oder Nickellegierungsoberfläche eines Artikels vor Oxidation, beinhaltend die folgenden Schritte:
(a) Herstellen eines Artikels, der eine Nickel- oder Nickellegierungsoberfläche aufweist,
(b) In-Kontakt-Bringen der Nickel- oder Nickellegierungsoberfläche des Artikels mit einer Zusammensetzung, die eine durch die folgende Formel (1) dargestellte Verbindung beinhaltet: 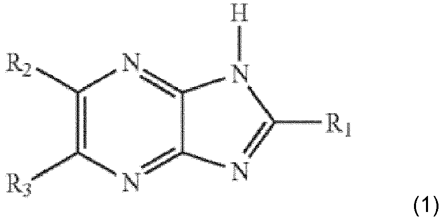 wobei R₁, R₂ und R₃ unabhängig Wasserstoff, substituiertes oder nichtsubstituiertes, lineares, verzweigtes oder cyclisches Alkyl, Halogenid, Nitro, Hydroxyl, Cyano, Carboxyl, Ester, Mercapto, Alkylthio, Thioester, Amino, Amid, Boryl oder Silyl sind; R₂ und R₃ mit all ihren Atomen zusammengenommen werden können, um einen fünfgliedrigen heterocyclischen Ring zu bilden, wobei der heterocyclische Ring zwei Stickstoffatome als die Heteroatome umfasst, und R₁ die folgende Struktur aufweisen kann: 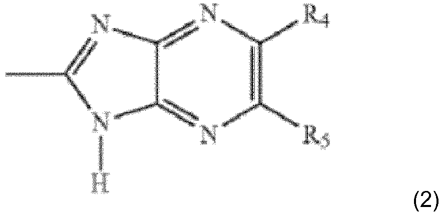 wobei R₄ und R₅ unabhängig Wasserstoff, Halogenid, Nitro, Hydroxyl, Cyano, substituiertes oder nichtsubstituiertes, lineares, verzweigtes oder cyclisches Hydrocarbyl, substituiertes oder nichtsubstituiertes, lineares oder verzweigtes Alkoxyl, Carboxyl, Ester, Mercapto, Alkylthio, Thioester, Amino, Amid, Boryl oder Silyl sind; R₄ und R₅ mit all ihren Atomen zusammengenommen werden können, um einen fünfgliedrigen heterocyclischen Ring zu bilden, wobei der heterocyclische Ring zwei Stickstoffatome als die Heteroatome umfasst, und
(c) Trocknen der Nickel- oder Nickellegierungsoberfläche zum Bilden eines die Verbindung beinhaltenden organischen Films auf der Oberfläche.

7. Verfahren gemäß Anspruch 6, wobei Schritt (b) über 1 bis 30 Minuten bei der Temperatur von 20 bis 70 °C durchgeführt wird.

8. Verfahren gemäß Anspruch 6, wobei der Artikel aus einer Leiterplatte, elektronischen Komponenten und dekorativem Zubehör ausgewählt ist.

## Revendications

1. Une méthode pour former un film organique sur une surface de nickel ou d'alliage de nickel comprenant la mise en contact de la surface de nickel ou d'alliage de nickel avec une composition comprenant un composé représenté par la formule (1) 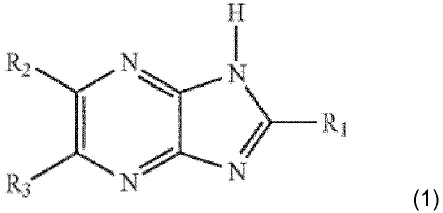 dans laquelle R₁, R₂ et R₃ sont indépendamment l'hydrogène, un alkyle linéaire, ramifié ou cyclique, substitué ou non substitué, un halogénure, un nitro, un hydroxyle, un cyano, un carboxyle, un ester, un mercapto, un alkylthio, un thioester, un amino, un amide, un boryle ou un silyle ; R₂ et R₃ peuvent être pris ensemble avec tous leurs atomes afin de former un anneau hétérocyclique à cinq chaînons, l'anneau hétérocyclique incluant deux atomes d'azote en tant qu'hétéroatomes, et R₁ peut avoir la structure suivante : 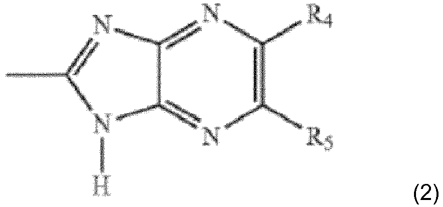 dans laquelle R₄ et R₅ sont indépendamment l'hydrogène, un halogénure, un nitro, un hydroxyle, un cyano, un hydrocarbyle linéaire, ramifié ou cyclique, substitué ou non substitué, un alcoxyle linéaire ou ramifié, substitué ou non substitué, un carboxyle, un ester, un mercapto, un alkylthio, un thioester, un amino, un amide, un boryle ou un silyle ; R₄ et R₅ peuvent être pris ensemble avec tous leurs atomes afin de former un anneau hétérocyclique à cinq chaînons, l'anneau hétérocyclique incluant deux atomes d'azote en tant qu'hétéroatomes.

2. La méthode de la revendication 1, dans laquelle le composé est inclus dans la composition en une quantité de 0,1 g/L à 50 g/L.

3. La méthode de la revendication 1, dans laquelle la composition comprend en outre des ions métalliques sélectionnés parmi Cu, Sn, Zn, Ag, Ni, Pd, Ba, Mg, Fe, Au, Pt, W, Bi, Sb, Mn et Pd.

4. Un film organique sur une surface de nickel ou d'alliage de nickel formé par la méthode de la revendication 1.

5. Le film organique de la revendication 4, dans lequel l'épaisseur du film va de 10 à 500 nm.

6. Une méthode pour protéger une surface en nickel ou en alliage de nickel d'un article contre l'oxydation, comprenant les étapes :
(a) de préparation d'un article ayant une surface en nickel ou en alliage de nickel,
(b) de mise en contact de la surface en nickel ou en alliage de nickel de l'article avec une composition comprenant un composé représenté par la formule (1) 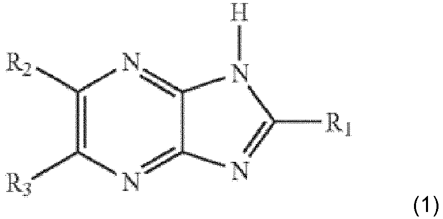 dans laquelle R₁, R₂ et R₃ sont indépendamment l'hydrogène, un alkyle linéaire, ramifié ou cyclique, substitué ou non substitué, un halogénure, un nitro, un hydroxyle, un cyano, un carboxyle, un ester, un mercapto, un alkylthio, un thioester, un amino, un amide, un boryle ou un silyle ; R₂ et R₃ peuvent être pris ensemble avec tous leurs atomes afin de former un anneau hétérocyclique à cinq chaînons, l'anneau hétérocyclique incluant deux atomes d'azote en tant qu'hétéroatomes, et R₁ peut avoir la structure suivante : 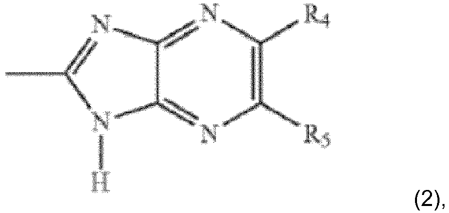 dans laquelle R₄ et R₅ sont indépendamment l'hydrogène, un halogénure, un nitro, un hydroxyle, un cyano, un hydrocarbyle linéaire, ramifié ou cyclique, substitué ou non substitué, un alcoxyle linéaire ou ramifié, substitué ou non substitué, un carboxyle, un ester, un mercapto, un alkylthio, un thioester, un amino, un amide, un boryle ou un silyle ; R₄ et R₅ peuvent être pris ensemble avec tous leurs atomes afin de former un anneau hétérocyclique à cinq chaînons, l'anneau hétérocyclique incluant deux atomes d'azote en tant qu'hétéroatomes, et
(c) de séchage de la surface en nickel ou en alliage de nickel afin de former un film organique comprenant le composé sur la surface.

7. La méthode de la revendication 6, dans laquelle l'étape (b) est effectuée à la température de 20 à 70 degrés C pendant 1 à 30 minutes.

8. La méthode de la revendication 6, dans laquelle l'article est sélectionné parmi une carte de circuit imprimé, des composants électroniques et des accessoires de décoration.
